# EUROPEAN PATENT APPLICATION

(11) **EP 1 120 997 A1**
(43) Date of publication of application: **01.08.2001**
(21) Application number: 00951906.7
(22) Date of filing: 09.08.2000
(51) Int. Cl.: H05B 3/10, H05B 3/16, H05B 3/18, H05B 3/20, H01L 21/027

(54) **CERAMIC HEATER**

(30) Priority: 10.08.1999 JP 22676999; 07.08.2000 JP 2000238779
(71) Applicant: IBIDEN CO., LTD., Ogaki-shi Gifu-ken 503-0917 (JP)
(72) Inventor: ITO, Yasutaka, c/o Ibiden Co Ltd, Ibi-gun, Gifu 501-0695 (JP); FURUKAWA, Masakazu, c/o Ibiden Co Ltd, Ibi-gun, Gifu 501-0695 (JP)
(74) Representative: Leson, Thomas Johannes Alois, Dipl.-Ing.
(86) International application number: JP0005322
(87) International publication number: WO0113679

(57) **Abstract**

An object of the present invention is to provide a ceramic heater making it possible to heat the whole of a subject to be heated uniformly. The ceramic heater of the present invention is a ceramic heater wherein a resistance heating element is arranged on a surface of a disc-shaped ceramic substrate or inside the substrate, characterized in that the resistance heating element is composed of a mixture of a resistance heating element having a concentric or spiral pattern and a resistance heating element having a pattern of repeated winding lines.

## Description

### Technical Field

The present invention relates to a ceramic heater used in the semiconductor industry.

### Background Art

A semiconductor product is produced through steps of forming a photosensitive resin as an etching resist on a semiconductor wafer, conducting etching the semiconductor wafer, and the like.

This photosensitive resin is liquid, and is applied onto a surface of the semiconductor wafer, using a spin coater and the like. In order to evaporate solvent and so on, the resin must be dried after the application. Thus, the semiconductor wafer subjected to the application is put on a heater and heated.

Hitherto, as a heater made of metal and used for such a purpose, a heater wherein resistance heating elements are arranged on the back surface of an aluminum plate is adopted.

However, such a heater made of metal has the following problems.

First, the thickness of the heater plate must be as thick as about 15 mm since the heater is made of metal. This is because: a bend, a strain and so on are generated in a thin metal plate because of thermal expansion resulting from heating so that a semiconductor wafer put on the metal plate is damaged or inclined. However, if the thickness of the heater plate is made thick, problems that the heater becomes heavy and bulky arise.

Heating temperature is controlled by changing the voltage or amperage applied to the resistance heating elements. However, if the metal plate is thick, the temperature of the heater plate does not follow the change in the voltage or amperage promptly. Thus,a problem that the temperature cannot be easily controlled is caused.

Thus, Japanese Kokai Publication Hei 9-306642, Japanese Kokai Publication Hei 4-324276 and so on suggest ceramic heaters wherein aluminum nitride, which is a non-oxidized ceramic having a large thermal conductivity and a large strength, is used as a substrate and resistance heating elements are formed, on a surface of this nitride aluminum substrate or inside the substrate.

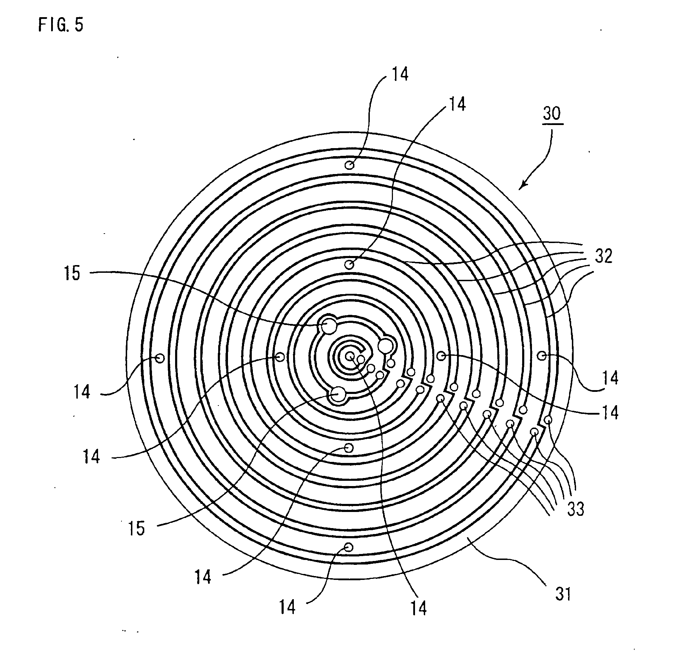

FIG. 5 is a bottom view that schematically shows a conventional ceramic heater.

In this ceramic heater 30, resistance heating elements 32 are formed into a concentric pattern on the bottom surface of a heater plate 31 as shown in FIG. 5. Reference number 33 represents an external terminal for connection to a power source and the like jointed to ends of the resistance heating elements 32. A surface for heating a semiconductor wafer (hereinafter referred to a wafer-heating surface) is a surface opposite to the surface on which the resistance heating elements 32 are disposed. The resistance heating elements 32 may be formed into a spiral form.

### Summary of the Invention

However, in the case that the ceramic heater 30 in which the resistance heating elements 32 are formed into such pattern of a concentric or spiral form is used to heat a semiconductor wafer and the like, the temperature in the whole of the wafer-heating surface does not become uniform even if the density of the resistance heating element pattern is uniform as a whole. As a result, a problem that a difference in temperature is generated between the central portion of the heated semiconductor wafer and the peripheral portion thereof arises.

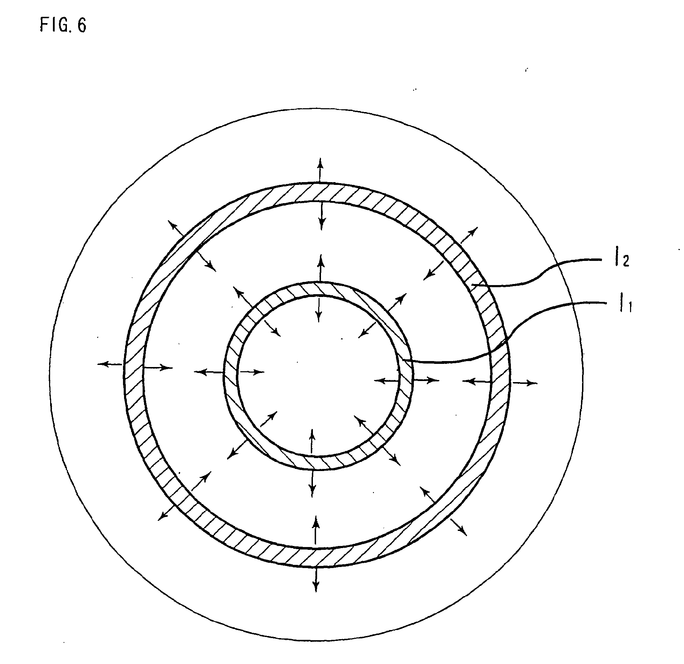

The above-mentioned problem will be described, referring to FIG. 6. When heat transmits from the resistance heating elements in a concentric form to the heater plate, an area where heat is transmitted from a resistance heating element l₂ composed of a large circle is larger than an area where heat is transmitted from a resistance heating element l₁ composed of a small circle. As a result, calorific value of the resistance heating element l₂ required for making the surface temperature of the heater plate uniform is larger than that of the resistance heating element l₁ required for the same.

For this reason, it can be considered that when resistance heating elements are formed into the same pattern and the same electric power is applied thereto, unevenness in temperature is generated in an object to be heated.

Therefore, it is necessary to change applying electric power depending on whether it is a inner portion or peripheral portion. However, it is difficult to perform subtle control.

The present inventor made eager investigations on the problems in the prior art. As a result, the inventor has found that the temperature of the heater plate can be made uniform by making the direction in which heat transmits not only to the direction of the heater diameter but also to a random direction.

The inventor has also found the following. Since the resistance heating elements are formed by printing, the following 2 kinds of portions are generated in a concentric or spiral pattern: a portion where the direction of the printing and the direction along which the resistance heating element is formed are substantially perpendicular to each other; and a portion where the two directions are parallel to each other. Thus, the thickness of the resistance heating elements variates between the portion perpendicular to the printing direction and' the portion parallel thereto, so that the ohmic value thereof varies. As a result, temperature-dispertion is generated. This fact is also a cause of the above-mentioned problems.

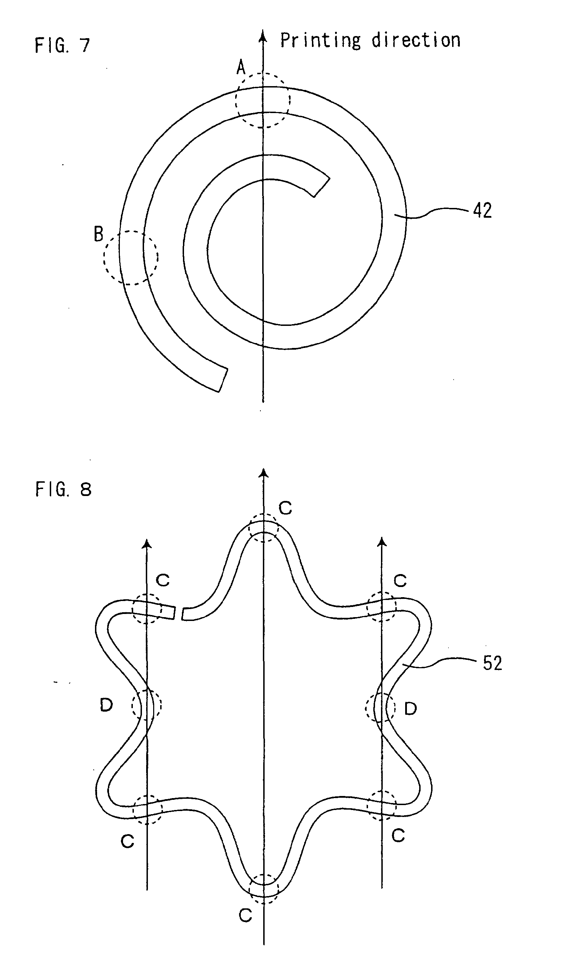

Concerning, for example, a resistance heating element 42 shown in FIG. 7, in a pattern in an area A where the direction of printing and the direction along which the resistance heating element is formed is substantially perpendicular to each other, the thickness of the resistance heating element tends to be thick. On the other hand, in a pattern in an area B where the printing direction and the resistance heating element formed direction is almost parallel to each other, the thickness of, the resistance heating element tends to be thin.

Accordingly, the area A has a low ohmic value and the area B has a high ohmic value.

It has found from the above-mentioned finding that: in the present invention the direction in which heat transmits can be made random by combining a concentric or spiral pattern with a pattern of repeated winding lines to form a resistance heating element, specifically by forming resistance heating elements having a conventional concentric pattern and the like in the inner portion of a disc-shaped ceramic substrate (at the center thereof) and forming a resistance heating element having a winding line form, which is different from the concentric pattern in the peripheral portion thereof; thus, a semiconductor wafer and so on can be uniformly heated as a whole.

Namely, the ceramic heater of the present invention is a ceramic heater wherein a resistance heating element is arranged on a surface of a disc-shaped ceramic substrate or inside the substrate,
characterized in that the resistance heating element is composed of a mixture of a resistance heating element having a concentric or spiral pattern and a resistance heating element having a pattern of a winding line or a pattern of repeated winding lines.

It is preferred in the present invention that the resistance heating element having the pattern of repeated winding lines is formed at least in a peripheral portion of the disc-shaped ceramic substrate.

### Brief Description of the Drawings

FIG. 1 is a bottom view that schematically shows an example of the ceramic heater of the present invention.

FIG. 2 is an enlarged partial sectional view that schematically shows a part of the ceramic heater shown in FIG. 1.

FIG. 3 is an enlarged partial sectional view that schematically shows a part of a ceramic heater according to the present invention wherein resistance heating elements are formed inside a heater plate.

FIG. 4 is a bottom view that schematically shows another example of the resistance heating element pattern in the ceramic heater of the present invention.

FIG. 5 is a bottom view that schematically shows a conventional ceramic heater.

FIG. 6 is a schematic view showing a state of heat conduction.

FIG. 7 is an explanatory view showing how a pattern of a spiral resistance heating element is printed.

FIG. 8 is an explanatory view showing how a pattern of a winding resistance heating element is printed.

FIG. 9 is a bottom view showing a pattern of a resistance heating element wherein a partially winding pattern and a spiral pattern are mixed.

### Explanation of symbols

10,20 ceramic heater
11,61 heater plate
11a bottom surface
11b wafer-heating surface
12a, 12b, 22a, 22b, 22c, 22d resistance heating element
42, 52, 62a, 62b, 62c, 62d, 72 resistance heating element
13, 73 external terminal
14, 74 bottomed hole
15, 75 through hole
16 lifter pin
17 metal covering layer
19 semiconductor wafer
76 plated through hole

### Detailed disclosure of the invention

The ceramic heater of the present invention is a ceramic heater wherein a resistance heating element is arranged on a surface of a disc-shaped ceramic substrate or inside the substrate,
characterized in that the resistance heating element is composed of a mixture of a resistance heating element having a concentric or spiral pattern and a resistance heating element having a pattern of a winding line or a pattern of repeated winding lines.

According to the ceramic heater of the present invention, above-mentioned resistance heating element is composed of a mixture of a concentric or spiral pattern and a pattern of a winding line or a pattern of repeated winding lines; therefore, a drop in temperature in the peripheral portion can be suppressed as compared with the case in which a resistance heating element having a concentric or spiral pattern is formed over whole surface of the ceramic substrate. Thus, temperature on the whole of the wafer-heating surface of the substrate becomes uniform so that a semiconductor wafer and the like can be uniformly heated.

FIG. 8 is a plain view that schematically shows a resistance heating element 52 composed of a pattern of repeated winding lines. In such a pattern made of a winding line, or a pattern of repeated winding lines, its winding portions are grouped into portions C where the direction of printing and the direction along which the resistance heating element is formed are substantially perpendicular to each other, and portions D where they are parallel to each other. Therefore, calorific value as a whole is made uniform. For this reason, it is possible to reduce temperature-dispersion generated by variation in the ohmic value in the resistance heating element 52.

A ceramic substrate constituting the ceramic heater of the present invention is made of a non-oxide ceramic such as nitride ceramic or carbide ceramic, or an oxide ceramic. An oxide ceramic may be formed, as an insulating layer, on a surface of the non-oxide ceramic.

This is because: the volume resistivity of a nitride ceramic drops easily in high temperature, for example, by making solid-solution with oxygen, and also a carbide ceramic has electrical conductivity so far as it is not made highly pure. Hence, by forming an oxide ceramic as an insulating layer, a short circuit between circuits can be prevented even at high temperature or even if the carbide ceramic contains impurities, therefore temperature controlling capability can be ensured.

A non-oxide ceramic has high thermal conductivity so that the temperature thereof can be promptly raised or lowered. Thus, a non-oxide ceramic is profitable. On the other hand, since a non-oxide ceramic has high thermal conductivity, temperature-dispersion is easily generated because of a pattern of the resistance heating element. Therefore, on a non-oxide ceramic, more significant effect is observed in making temperature uniform by forming a resistance heating element having such a pattern as in the present invention, compared to' an oxide ceramic. Thus, the structure of the present invention is particularly profitable.

Regarding the surface roughness of the face (bottom surface) opposite to the heating-surface of the ceramic substrate, Ra is desirably 0.01 to 20 µm and Rmax is desirably 0.1 to 200 µm.

Examples of the nitride ceramic constituting the ceramic substrate include metal nitride ceramics such as aluminum nitride, silicon nitride, boron nitride and titanium nitride.

Examples of the carbide ceramic include metal carbide ceramics such as silicon carbide, zirconium carbide, titanium carbide, tantalum carbide and tungsten carbide.

As the ceramic substrate, an oxide ceramic may be used. Alumina, silica, cordierite, mullite, zirconia, beryllia and the like are the examples.

The nitride ceramic, the carbide ceramic and oxide ceramic may be used alone or in combination of two or more.

Among these, the nitride ceramic is preferred and aluminum nitride is most preferred. This is because its thermal conductivity is highest, that is, 180 W/m • K.

The substrate of the non-oxide ceramic, such as the nitride ceramic or the carbide ceramic, has high thermal conductivity so that the surface temperature of the heater plate can be made to follow a change in the temperature of the resistance heating element promptly to control the temperature of the wafer-heating surface satisfactorily. Moreover, its mechanical strength is large. For these reasons, it does not happen that the heater plate warps, and a semiconductor wafer put thereon can be prevented from being damaged.

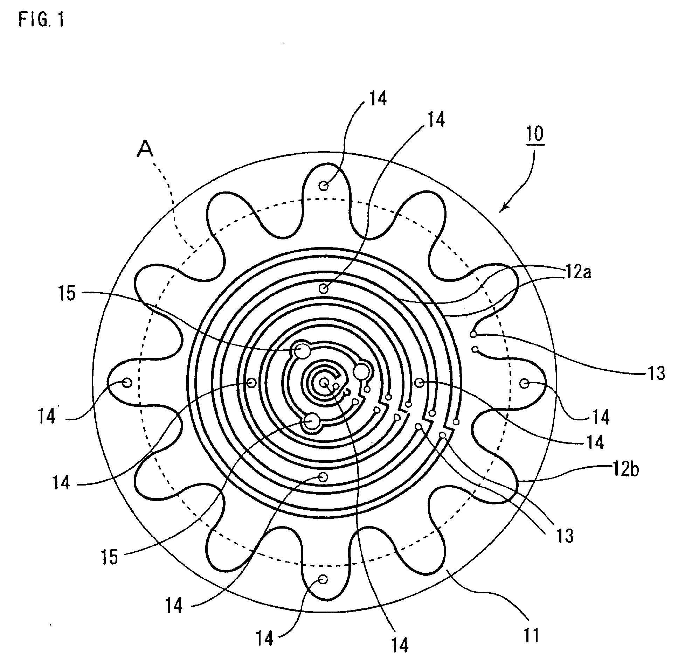

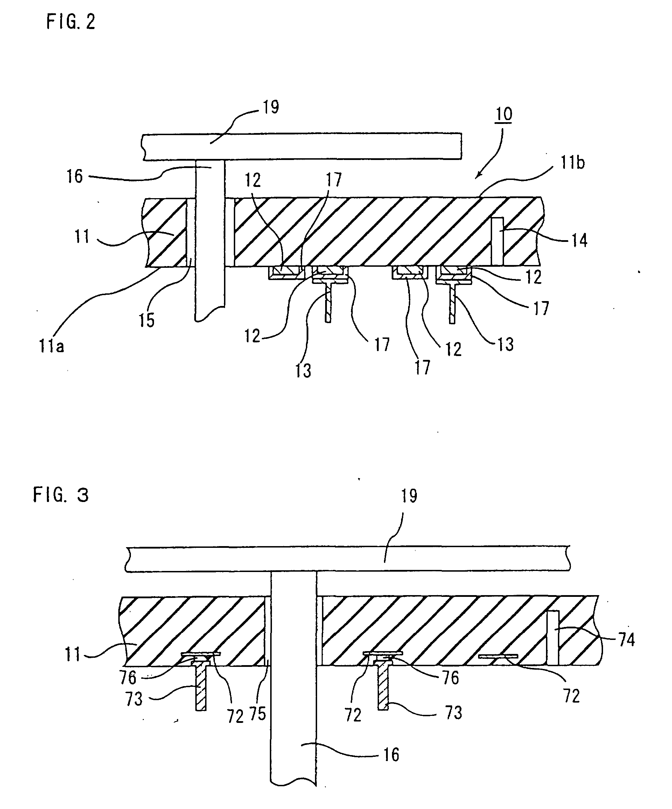

FIG. 1 is a bottom view that schematically shows an example of the ceramic heater of the present invention. FIG. 2 is an enlarged partial sectional view that shows a part thereof.

A heater plate 11 composed of a ceramic substrate made of a nitride ceramic, a carbide ceramic, an oxide ceramic and the like (the substrate may be referred to as a ceramic substrate made of a nitride and the like hereinafter) is formed in a disk-form. In order to heat a wafer-heating surface llb of the ceramic substrate (which may be referred to as the heater plate) 11 in the manner that the temperature of the whole thereof is made uniform, resistance heating elements 12a having a concentric pattern are formed inner portion of a bottom surface lla of the heater plate 11. On the other hand, a resistance heating element 12b having a pattern of repeated winding lines is formed in the peripheral portion of the heater plate 11.

In the inner resistance heating element 12a, two concentric circles near to each other, as one set, are connected into one line. External terminals 13, which will be input/output terminals, are connected to two ends thereof through metal covering layers 17. Through holes 15 into which supporting pins 16 for supporting a semiconductor wafer 19 are inserted are made in areas near the center. Bottomed holes 14 into which temperature measuring elements are inserted are also made.

In the ceramic heater 10 shown in FIGs. 1 and 2, a resistance heating element 12 is arranged on the bottom surface of the heater plate 11. As shown in FIG. 3, resistance heating elements 72 may be arranged inside the heater plate 11. In the case that the resistance heating elements 72 are arranged inside the heater plate 11, the pattern of the resistance heating elements 12 is formed in the same manner as in the case that the resistance heating elements are arranged on the bottom surface. In the case that the resistance heating elements 72 are arranged inside the heater plate 11, external terminals 73 are connected through plated through holes 76 and solder material (not illustrated) . A through hole 75 is made in the heater plate 11 in the manner that a lifter pin 16 can be inserted into the hole. Bottomed holes 74 in which temperature-measuring elements such as thermocouples are embedded are also made.

In the ceramic heater 10 of the present invention, a ceramic such as nitride is used as the material of the heater plate. This is based on the following reason. The ceramic has a smaller thermal expansion coefficient than metals. Thus, even if the ceramic is made thin, the ceramic is not warped or distorted by heating. As a result, the heater plate 11 can be made thin and light.

Since the thermal conductivity of the heater plate 11 is high and the heater plate itself is thin, the surface temperature of the heater plate 11 follows a change in the temperature of the resistance heating element promptly. In other words, the surface temperature of the heater plate 11 can be satisfactorily controlled by changing voltage or amperage to change the temperature of the resistance heating element.

The thickness of the heater plate 11 in the ceramic heater is preferably 0.5 to 5 mm. If the thickness is thinner than 0.5 mm, the strength is lowered so that the heater plate is easily damaged. On the other hand, if the thickness is thicker than 5 mm, heat does not transmit easily so that heating efficiency deteriorates.

In the ceramic heater shown in FIGs. 1 and 2, the concentric resistance heating elements 12a are formed inner portion of it, but the resistance heating element may be spiral.

On the other hand, in the peripheral portion, the resistance heating element 12b having a pattern of repeated winding lines is formed. The degree of the winding repetition. of the winding lines may be more per unit length. Namely, the number of the winding of the resistance heating element 12b shown in FIG. 1 may be more.

In the resistance heating element 12b composed of the winding line in FIG. 1, its portion similar to a straight line is formed to perpendicularly cross a broken line A drawn in the peripheral portion. Conversely, a large number of small winding lines in which the portion similar to a straight line is substantially parallel to the broken line A may also be formed in parallel to the circumferential direction.

Incidentally, inner portion means a circular portion within the scope from the center of the heater plate 11 to 1/3 of the radius thereof, and the other portions are referred to as the peripheral portion.

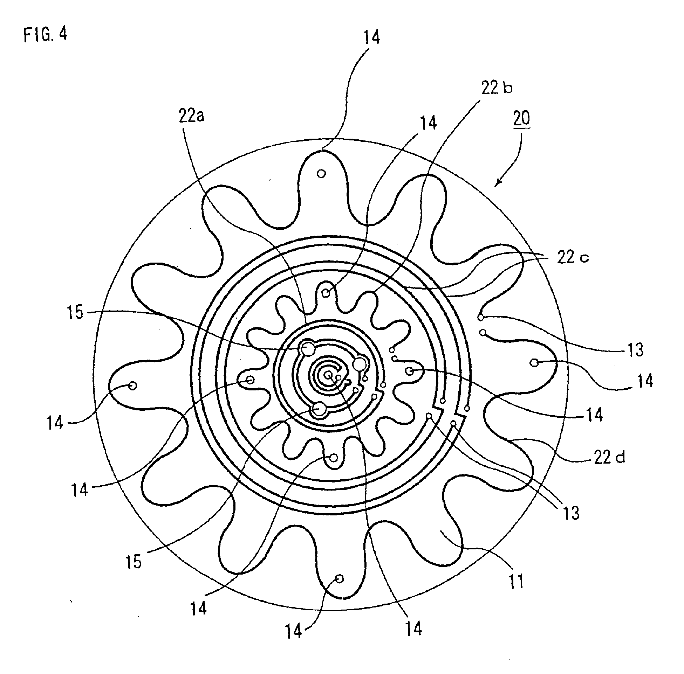

In the present invention, it is sufficient that at least the peripheral portion has the pattern of repeated winding line. Therefore, as shown in FIG. 4, resistance heating elements 22b and 22d composed of a pattern of repeated winding lines are arranged between resistance heating elements 22a and 22c composed of an inner spiral pattern and/or a concentric pattern.

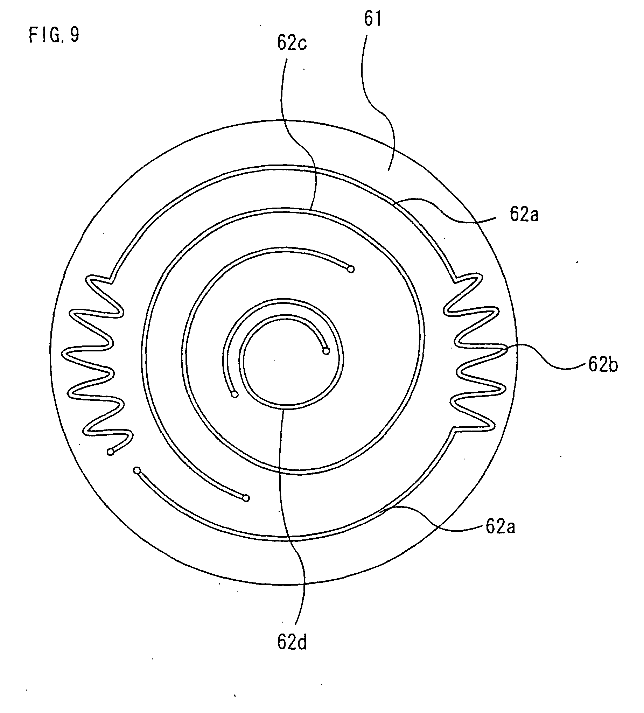

As shown in FIG. 9, the following is also allowable: in the peripheral portion of the bottom surface of the heater plate 61 is formed with a pattern wherein each of resistance heating elements 62b composed of a pattern of repeated winding lines is interposed between resistance heating elements 62a composed of a concentric pattern; and concentric patterns 62c and 62d are formed inner portion of the plate 61.

The resistance heating element 12 formed on the surface of the ceramic substrate made of a nitride and the like, or inside the substrate is desirably divided into two or more circuits as shown in FIG. 1. By the division into the circuits, electric power introduced into the respective circuits can be controlled to change heat quality. Thus, the temperature of the surface for heating a semiconductor wafer can be adjusted.

In the case that the resistance heating element 12 is formed on the surface of the heater plate 11, the following method is preferred: a method of applying a conductor containing paste containing metal particles to the surface of the heater plate 11 to form a conductor containing paste having a given pattern, and firing this to sinter and the bake the metal particles on the surface of the heater plate 11. If the fusion occurs between metal particles and between the ceramics and metal particles at the sintering of the metal, the sintering is sufficient.

When the resistance heating element is formed on the surface of the heater plate 11, the thickness of the resistance heating element is preferably 1 to 30 µm and more preferably 1 to 10 µm. When the resistance heating element is formed inside the heater plate 11, the thickness is preferably 1 to 50 µm.

When the resistance heating element is formed on the surface of the heater plate 11, the width of the resistance heating element is preferably 0.1 to 20 mm and more preferably 0.1 to 5 mm. When the resistance heating element is formed inside the heater plate 11, the width of the resistance heating element is preferably 5 to 20 µm.

The ohmic value of the resistance heating element 12 can be changed dependently on its width or its thickness. The above-mentioned ranges are however most practical. The ohmic value becomes larger as the resistance heating element becomes thinner and narrower. The thickness and the width of the resistance heating element 12 become larger in the case that the resistance heating element 12 is formed inside the heater plate 11. This is because: when the resistance heating element 12 is formed inside, the distance between the heating surface and the resistance heating element 12 becomes short so that the' uniformity of the temperature in the surface drops, thus, it is necessary to broaden the width of the resistance heating element itself. When the resistance heating element 12 is formed inside, it is unnecessary to consider the adhesiveness to any ceramic, for example, nitride. Therefore, it is possible to use a high melting point metal such as tungsten or molybdenum, or a carbide of tungsten, molybdenum and the like and, thus the ohmic value can be made high. For these reasons, the thickness itself may be broaden in order to prevent disconnection and so on. There are the reasons why resistance heating element 12 is preferred to have the above-mentioned thickness and width.

The sectional shape of the resistance heating element 12 may be rectangular or elliptical, and is preferably flat. The flat sectional shape makes it possible to radiate heat more easily toward the wafer-heating surface. Therefore, temperature-distribution in the heating surface is not easily generated.

The aspect ratio (the width of the resistance heating element/the thickness of the resistance heating element) of the section is desirably 10 to 5000.

Adjustment thereof into this range makes it possible to increase the ohmic value of the resistance heating element 12 and keep the uniformity of the temperature in the heating surface.

In the case that the thickness of the resistance heating element 12 is made constant, the amount of heat transmission toward the wafer-heating surface of the heater plate 11 becomes small if the aspect ratio is smaller than the above-mentioned range. Thus, thermal distribution similar to the pattern of the resistance heating element 12 is generated in the heating surface. On the other hand, if the aspect ratio is too large, the temperature of the portion just above the center of the resistance heating element 12 becomes high so that thermal distribution similar to the pattern of the resistance heating element 12 is generated in the heating surface. Accordingly, if temperature distribution is considered, the aspect ratio of the section is preferably 10 to 5000.

When the resistance heating element 12 is formed on the surface of the heater plate 11, the aspect ratio is desirably 10 to 200. When the resistance heating element 12 is formed inside the heater plate 11, the aspect ratio is desirably 200 to 5000.

The aspect ratio becomes larger in the case that the resistance heating element is formed inside the heater plate 11. This is based on the following reason. If the resistance heating element 12 is formed inside, the distance between the heating surface and the resistance heating element 12 becomes short so that temperature uniformity on the surface falls. It is therefore necessary to make the resistance heating element 12 itself flat.

When the resistance heating element 12 is formed in biased position inside the heater plate 11, the position is desirably a position close to the surface (bottom surface) which is opposite to the heating surface of the heater plate 11 and within the domain extending from the bottom surface in 50 % to 99 % of the distance from the heating surface to the bottom surface.

If the value defining the domain is 50 % or less, the position is too close to the heating surface so that temperature-dispersion is caused. Contrarily, if the value is over 99 %, the heater plate 11 itself warps to damage a semiconductor wafer.

In the case that the resistance heating element 12 is arranged inside the heater plate 11, a plurality of resistance heating element forming layers may be formed. In this case, the patterns of the respective layers are desirably in the state that the resistance heating element 12 is formed on some layer so as to be complementary to each other so that, as viewed from a position above the wafer-heating surface, any one of the patterns is formed in any area. A preferred example of such a structure is a structure of a staggered arrangement.

It is allowable that the resistance heating element 12 is formed inside the heater plate 11 and a part of the resistance heating element 12 is exposed.

The conductor containing paste is not particularly limited, and is preferably a paste comprising not only metal particles or a conductive ceramic for keeping electrical conductivity but also a resin, a solvent, a thickener and so on.

The metal particles are preferably made of, for example, a noble metal (gold, silver, platinum and palladium), lead, tungsten, molybdenum, nickel and the like. These may be used alone or in combination of two or more. These metals are not relatively easily oxidized, and have an ohmic value sufficient for generating heat.

Examples of the conductive ceramic include carbides of tungsten and molybdenum. These may be used alone or in combination of two or more.

The particle diameter of these metal particles or the conductive ceramic is preferably 0.1 to 100 µm. If the particle diameter is too fine, that is, below 0.1 µm, they are easily oxidized. On the other hand, if the particle diameter is over 100 µm, they are not easily sintered so that the ohmic values becomes large.

The shape of the metal particles is spherical or scaly. When these metal particles are used, they may be a mixture of spherical particles and scaly particles.

In the case that the metal particles are scaly or a mixture of spherical particles and scaly particles, oxides between the metal particles are easily retained and adhesiveness between the resistance heating element 12 and the ceramic such as nitride is made sure. Moreover, the ohmic value can be made large. Thus, this case is profitable.

Examples of the resin used in the conductor containing paste include epoxy resins and phenol resins. An example of the solvent is isopropyl alcohol and the like. An example of the thickener is cellulose and the like.

As described above, it is desired to add an oxide to the metal particles in the conductor containing paste and make the resistance heating element 12 to a sintered product of the metal particles and the oxide. By sintering the oxide together with the metal particles, the ceramic, such as nitride, constituting the heater plate can be closely adhered to the metal particles.

The reason why the adhesiveness to the ceramic such as nitride is improved by mixing the oxide is unclear, but it is considered that based on the following reasons. The surface of the metal particles, or the surface of the ceramic such as nitride, particularly the ceramic of non-oxide, is slightly oxidized so that an oxidized film is formed thereon. These oxidized films are sintered and integrated with each other through oxide so that the metal particles and the ceramic such as nitride are closely adhered to each other.

A preferred example of the oxide is at least one selected from the group consisting of lead oxide, zinc oxide, silica, boron oxide (B₂O₃), alumina, yttria, and titania.

These oxides make it possible to improve adhesiveness between the metal particles and the ceramic such as nitride without increasing the ohmic value of the resistance heating element 12.

When the total amount of the metal oxides is set to 100 parts by weight, the weight ratio of lead oxide, zinc oxide, silica, boron oxide (B₂O₃), alumina, yttria and titania is as follows: lead oxide: 1 to 10, silica: 1 to 30, boron oxide: 5 to 50, zinc oxide: 20 to 70, alumina: 1 to 10, yttria: 1 to 50 and titania: 1 to 50. The ratio is preferably adjusted within the scope that the total thereof is not over 100 parts by weight.

By adjusting the amounts of these oxides within these ranges, the adhesiveness to the ceramic such as nitride can be particularly improved.

The addition amount of the metal oxides to the metal particles is preferably 0.1 % by weight or more, and less than 10 % by weight. The area resistivity when the conductor containing paste having such a structure is used to form the resistance heating element 12 is preferably from 1 to 45 mΩ/□.

If the area resistivity is over 45 mΩ/□, the calorific value to an applied voltage becomes too large so that, in the heater plate 11 devices wherein resistance heating element 12 is set on its surface, its calorific value is not easily controlled. If the addition amount of the metal oxides is 10 % or more by weight, the area resistivity exceeds 50 mΩ/□ so that the calorific value becomes too large. Thus, temperature-control is not easily performed so that the uniformity in temperature distribution falls.

In the case that the resistance heating element 12 is formed on the surface of the heater plate 11, a metal covering layer 17 is preferably formed on the surface of the resistance heating element 12. The metal covering layer prevents a change in the ohmic value arising from oxidization of the inner metal sintered product. The thickness of the formed metal covering layer 17 is preferably from 0.1 to 10 µm.

The metal used when the metal covering layer 17 is formed is not particularly limited if the metal is a metal which is hardly oxidized. Specific examples thereof include gold, silver, palladium, platinum, and nickel. These may be used alone or in combination of two or more. Among these metals, nickel is preferred.

In the resistance heating element 12, a terminal for connecting it to a power source is necessary. This terminal is fixed to the resistance heating element 12 through solder. Nickel prevents solder from being thermally diffused. An example of the connecting terminal is an external terminal 13 made of koval.

In the case that the resistance heating element 12 is formed inside the heater plate 11, no coating is necessary since the surface of the resistance heating element 12 is not oxidized. In the case that the resistance heating element 12 is formed inside the heater plate 11, a part of the resistance heating element may be exposed in the surface. It is allowable that a plated through hole for connecting the resistance heating element 12 is made in a portion for the terminal and an external terminal may be connected and fixed to this through hole.

In the case that the external terminal 13 is connected, an alloy such as silver-lead, lead-tin or bismuth-tin can be used as a solder. The thickness of the solder layer is desirably from 0.1 to 50 µm. This is because this range is a range sufficient for maintaining the connection based on the solder.

As shown in FIG. 2, a through hole 15 is made in the heater plate 11 and a lifter pin 16 is inserted into the through hole 15 to make it possible to transfer a semiconductor wafer to a non-illustrated carrier or receive the semiconductor wafer from the carrier.

The face opposite to the resistance heating element formed surface of the heater plate is a surface for heating a product to be heated.

If necessary, in the present invention a thermocouple may be buried in the ceramic substrate. This is because the thermocouple makes it possible to measure the temperature of the resistance heating element and, based on the resultant data, voltage or electric current is changed so that the temperature can be controlled.

The size of the connecting portions of metal lines of they thermocouples is the same as the strand diameter of the respective metal lines or more, and is preferably 0.5 mm or less. Such a structure makes the thermal capacity of the connecting portion small, and enables a temperature to be correctly and speedy converted to a current value. For this reason, temperature control ability is improved so that the temperature distribution of the heated surface of the wafer-heating surface. becomes small.

Examples of the thermocouple include K, R, B, S, E, J and T type thermocouples, described in JIS-C-1602 (1980).

The thickness of the heater plate of the present invention, is desirably 50 mm or less, and especially desirably 20 mm or less. If the thickness of the heater plate is over 20 mm, the thermal capacity of the heater plate is too large, so that particularly when a temperature control means is set up to heat or cool the plate, temperature-following property may fall because of the large thermal capacity.

Also, the problem of temperature-unevenness that the present invention solves is not easily caused in the heater plate whose thickness is thick, that is, more than 20 mm.

The thickness is optimally 5 mm or less. The thickness is desirably 1 mm or more.

The diameter of the heater plate of the present invention is desirably 200 mm or more. It is especially desirable that the diameter is 12 inches (300 mm) or more. This is because semiconductor wafers having such a diameter become main currents of the next-generation semiconductor wafers. This is also because the problem of temperature-unevenness that the present invention solves is not easily caused in the heater plate having a diameter of 200 mm or less.

In the present invention, a product to be heated may be directly put on the heating surface, or may be heated in the state that the product is 5 to 5000 µm apart.

The following will describe the process for producing a ceramic heater of the present invention.

The following description is a process for producing a ceramic heater (see FIGs. 1 and 2) wherein a resistance heating element is formed on the bottom surface of the heater plate 11.

### (1) Step of making the heater plate

If necessary, a sintering aid such as yttria (Y₂O₃) or B₄C, a compound containing Na or Ca, a binder and so on are blended with ceramic powder made of a nitride and the like, such as aluminum nitride or silicon carbide to prepare a slurry. Thereafter, this slurry is made into a granule form by spray drying and the like. The granule is put into a mold and pressed to be formed into a plate form and the like form. Thus, a raw formed body (green) is formed.

Next, a portion that will be a through hole into which a lifter pin for supporting a semiconductor wafer is inserted, or portions that will be bottomed holes in which temperature-measuring elements such as thermocouples are embedded are made in the raw formed body if necessary.

Next, this raw formed body is heated and fired to be sintered. Thus, a plate made of the ceramic is produced. Thereafter, the plate is made into a given shape to produce the heater plate 11. The shape after the firing may be such a shape that the sintered product can be used as it is. By heating and firing the raw formed body under pressure, the heater plate 11 having no pores can be produced. It is sufficient that the heating and the firing are performed at sintering temperature or higher. The firing temperature is 1000 to 2500 °C for nitride ceramics or carbide ceramics, and is 1500 to 2000 °C for oxide ceramics.

### (2) Step of printing a conductor containing paste on the heater plate

A conductor containing paste is generally a fluid comprising metal particles, a resin and a solvent, and has a high viscosity. This conductor containing paste is printed in a portion where a resistance heating element is to be arranged by screen printing and the like, to form a conductor containing paste layer. Since it is necessary that the resistance heating element makes the temperature of the whole of the heater plate uniform, the conductor containing paste is printed into a pattern of a combination of concentric circles and a winding line, as shown in FIG. 1.

The conductor containing paste is desirably formed in the manner that a section of the resistance heating element 12 after the firing is rectangular and flat.

### (3) Firing of the conductor containing paste

The conductor containing paste printed on the bottom surface of the heater plate 11 is heated and fired to remove the resin and the solvent and sinter the metal particles . Thus, the conductor containing paste is baked onto the bottom surface of the heater plate 11 to form the resistance heating element 12. The heating and firing temperature is preferably 500 to 1000 °C.

When the above-mentioned oxides are added to the conductor containing paste, the metal particles, the heater plate and the oxides are sintered to be integrated with each other. Thus, the adhesiveness between the resistance heating element and the heater plate is improved.

### (4) Step of forming a metal covering layer

The metal covering layer 17 is desirably formed on the surface of the resistance heating element 12. The metal covering layer 17 can be formed by electroplating, electroless plating, sputtering and the like. From the viewpoint of mass-productivity, electroless plating is optimal.

### (5) Attaching of terminal pins and the like

Terminals (external terminals 13) for connecting with at power source are attached up to ends of the pattern of the resistance heating element 12 with solder. Thermocouples are fixed to the bottomed holes 14 with silver solder, gold solder and the like. The holes are sealed with a heat-resistant resin such as polyimde to finish production of the ceramic heater.

The following will describe a process for producing a ceramic heater (see FIG. 3) wherein the resistance heating elements 72 are formed inside the heater plate 11.

### (1) Step of making the heater plate

First, powder of a ceramic such as a nitride is mixed with a binder, a solvent and so on to prepare a paste. This is used to form a green sheet.

As the above-mentioned powder of a ceramic such as a nitride, aluminum nitride and so on can be used. If necessary, a sintering aid such as yttria or a compound containing Na or Ca may be added.

As the binder, desirable is at least one selected from an acrylic binder, ethylcellulose, butylcellusolve, and polyvinyl alcohol.

As the solvent, desirable is at least one selected from α-terpineol and glycol.

A paste obtained by mixing these is formed into a sheet form by the doctor blade method to form a green sheet.

The thickness of the green sheet is preferably 0.1 to 5 mm.

Next, the following are made in the resultant green sheet if necessary: a portion which will be a through hole 75 into which a support pin for supporting a silicon wafer is inserted; portions which will be bottomed holes 74 in which the thermocouples are buried; portions which will be plated through holes 76 for connecting the resistance heating element to the external terminals 73; and so on. After a green sheet lamination that will be described later is formed, the above-mentioned processing may be performed.

### (2) Step of printing a conductor containing paste on the green sheet

A metal paste or a conductor containing paste containing a conductive ceramic, for forming the resistance heating element, is printed on the green sheet. The pattern of the printing at this time is made to be a pattern of a combination of concentric circles and a winding line as shown in FIG. 1.

These conductor containing paste contains the metal particles or the conductive ceramic particles.

The average particle diameter of tungsten particles or molybdenum particles is preferably 0.1 to 5 µm. If the average particle is below 0.1 µm or over 5 µm, the conductor containing paste is not easily printed.

Such a conductor containing paste may be a composition (paste) obtained by mixing, for example, 85 to 87 parts by weight of the metal particles or the conductive ceramic particles; 1.5 to 10 parts by weight of at least one binder selected from acrylic binders, ethylcellulose, butylcellusolve and polyvinyl alcohol; and 1.5 to 10 parts by weight of at least one solvent selected from α-terpineol and glycol.

### (3) Step of laminating the green sheets

Green sheets on which no conductor containing paste is printed are laminated on the upper and lower sides of the green sheet on which the conductor containing paste is printed.

At this time, the number of the green sheet laminated on the upper side is made larger than that of the green sheet laminated on the lower side to cause the position where the resistance heating element is formed to be biased toward the bottom surface.

Specifically, the number of the green sheets laminated on the upper side is preferably 20 to 50, and that of the green sheets laminated on the lower side is preferably 5 to 20.

### (4) Step of firing the green sheet lamination

The green sheet lamination is heated and pressed to sinter the green sheets and the inner conductor containing paste.

The heating temperature is preferably 1000 to 2000 °C, and the pressing pressure is preferably 100 to 200 kg/cm². The heating is performed in the atmosphere of an inert gas. As the inert gas, argon, nitrogen and the like can be used.

After the sintering, bottomed holes into which temperature-measuring elements are inserted may be made. They bottomed holes can be made by blast treatment such as sandblast after surface-polishing. External terminals 73 are connected to plated through holes 76 for connecting to the inner resistance heating element, and then the resultant is heated for reflowing. The heating temperature is suitably 200 to 500 °C.

Furthermore, thermocouples and the like as temperature-measuring elements are fitted to the holes with silver solder, gold solder and the like, and then the holes are sealed with a heat-resistant resin such as polyimide to finish the production of the ceramic heater.

The ceramic heater of the present invention can be used as an electrostatic chuck or a chuck top stage of a wafer prober.

### Best Modes for Carrying Out the Invention

The present invention will be described in more detailed hereinafter.

### (Example 1)

(1) A composition made of 100 parts by weight of aluminum nitride powder (average particle diameter: 1.1 µm), 4 parts by weight of yttria (average particle diameter: 0.4 µm), 12 parts by weight of an acrylic binder and an alcohol was subjected to spray-drying to make granular powder.
(2) Next, this granular powder was put into a mold and formed into a flat plate form to obtain a raw formed body (green).
(3) The raw formed body subjected to the above-mentioned working treatment was hot-pressed at 1800 °C and a pressure of 20 MPa to obtain a nitride aluminum plate having a thickness of 3 mm.
   Next, this plate was cut out into a disk having a diameter of 210 mm to prepare a plate (heater plate 11) made of the ceramic. This formed body was subjected to drilling to make a portion which would be the through hole 15, into which a supporting pink of a semiconductor wafer is inserted, and portions (diameter: 1.1 mm, and depth: 2 mm) which would be the bottomed holes 14, in which thermocouples are embedded.
(4) A conductor containing paste was printed on the heater plate 11 obtained in the step (3) by screen printing. The pattern of the printing was made to a pattern of a combination of concentric circles and a winding line as shown in FIG. 1. This may be such a pattern as in the ceramic cheater 20 shown in FIG. 4.
   The used conductor containing paste was Solvest PS603D made by Tokuriki Kagaku Kenkyu-zyo, which is used to form plated through holes in printed circuit boards.
   This conductor containing paste was a silver-lead paste and contained 7.5 parts by weight of oxides comprising lead oxide(5 % by weight), zinc oxide (55% by weight), silica (10% by weight), boron oxide (25% by weight) and alumina (5% by weight) per 100 parts by weight of silver. The silver particles had an average particle diameter of 4.5 µm, and were scaly.
(5) Next, the heater plate 11 on which the conductor containing paste was printed was heated and fired at 780 °C to sinter silver and lead in the conductor containing paste and bake them onto the heater plate 11. Thus, the resistance heating element 12 was formed. The silver-lead resistance heating element had a thickness of 5 µm, a width of 2.4 mm and a area resistivity of 7.7 mΩ/□. A dispersion in the thickness was ± 0.4 µm. However, the dispersion was not localized.
(6) The heater plate 11 formed in the step (5) was immersed into an electroless nickel depositing bath comprising an aqueous solution containing 80 g/L of nickel sulfate, 24 g/L of sodium hypophosphite, 12 g/L of sodium acetate, 8 g/L of boric acid, and 6 g/L of ammonium chloride to precipitate the metal covering layer (nickel layer) 17 having a thickness of 1 µm on the surface of the silver-lead resistance heating element 12.
(7) A silver-lead solder paste (made by Tanaka Kikinzoku kogyo.Co) was printed to form a solder layer by screen printing on portions to which the external terminals 13 for attaining connection to a power source were attached.
   Next, the external terminals 13 made of koval were put on the solder layer and heated at 420 °C for reflowing to attach the external terminals 13 onto the surface of the resistance heating element.
(8) Thermocouples for controlling temperature were fitted into the holes and a ceramic adhesive (Aron ceramic, made by Toagosei Co., Ltd.) was filled thereto, so as to obtain the ceramic heater 10.

### (Example 2)

(1) A paste obtained by mixing 100 parts by weight of aluminum nitride powder (made by Tokuyama Corp., average particle diameter: 1.1 µm), 4 parts by weight of yttrium oxide (Y₂O₃: yttria, average particle diameter: 0.4 µm), 11 parts by weight of an acrylic binder, 0.5 part by weight of a dispersant, and 53 parts by weight of alcohols composed of 1-butanol and ethanol was formed by the doctor blade method to produce a green sheet having a thickness of 0.47 µm.
(2) Next, this green sheet was dried at 80 °C for 5 hours, and was subjected to punching to make a portion which would be the through holes 75, into which the lifter pin 16 for performing carriage of the semiconductor wafer 19 shown in FIG. 3 and the like conduct is inserted, portions which would be via holes, and portions which would be the plated through holes 76.
(3) 100 parts by weight of tungsten carbide particles having an average particle diameter of 1 µm, 3.0 parts by weight of an acrylic binder, 3.5 parts by weight of α-terpineol solvent, and 0.3 part by weight of a dispersant were mixed to prepare a conductor containing paste A.
   100 parts by weight of tungsten particles having an average particle diameter of 3 µm, 1.9 parts by weight of an acrylic binder, 3.7 parts by weight of α-terpineol solvent, and 0.2 part by weight of a dispersant were mixed to prepare a conductor containing paste B.
   This conductor containing paste A was printed to form a conductor containing paste layer for resistance heating elements by screen printing on the green sheet in which the portions which would be the via holes were made. The printed pattern was a spiral pattern and a partially winding pattern as shown in FIG. 9. The width of the conductor containing paste layer was 10 mm, and the thickness thereof was 12 µm. A dispersion in the thickness was ± 0.5 µm as a whole but the dispersion was not localized.
   Subsequently, the conductor containing paste A was printed by screen printing on the green sheet in which the portions which would be the plated through holes were made, to form a conductor containing paste for conductor circuits. The printed form was band-like.
   The conductor containing paste B was filled into the portions which would be the via holes and the portion which would the plated through holes.
   Thirty seven green sheets on which no conductor containing paste was printed were stacked on the green sheet subjected to the above-mentioned treatment, on which the conductor containing paste was printed. The green sheet one which the conductor containing paste was printed was stacked on the bottom side of the resultant. Furthermore, 12 green sheets on which no conductor containing paste was printed were stacked on the bottom side thereof, and then the green sheets were laminated at 130 °C and a pressure of 8 MPa.
(4) Next, the resultant lamination was degreased at 600 °C in nitrogen gas for 5 hours, and hot-pressed at 1890 °C and a pressure of 15 MPa for 10 hours to obtain a ceramic plate 3 mm in thickness. This was cut out into a disc of 230 mm in diameter to prepare the heater plate 11 having therein the resistance heating elements 72 having a thickness of 6 µm and a width of 10 mm inside and the plated through holes 76.
(5) Next, the heated plate 11 obtained in the step (4) was polished with diamond grindstone, and then a mask was put thereon to make the bottomed holes 74 for thermocouples on the surface by blast treatment with SiC and the like.
(6) Thermocouples for controlling temperature were fitted into the bottomed holes 74. Silica sol was filled into the holes and hardened and gelled at 190 °C for 2 hours to obtain a ceramic heater having the resistance heating elements 72 and the through holes 76.

### (Example 3)

(1) A composition made of 100 parts by weight of SiC powder (average particle diameter: 0.3 µm), 0.5 part by weight of B₄C as a sintering aid, 12 parts by weight of an acrylic binder and an alcohol was subjected to spray-drying to make granular powder.
(2) Next, this granular powder was put into a mold and formed into a flat plate form to obtain a raw formed body(green).
(3) The raw formed body subjected to the above-mentioned working treatment was hot-pressed at 2100 °C and a pressure of 18 MPa to obtain a SiC ceramic plate having a thickness of 3 mm.
   Next, this plate was cut out into a disk having a diameters of 210 mm to prepare a heater plate.
   A glass paste (made by Shouei Chemical Products Co., Ltd., G-5232N) was applied to the heater plate, and the heater plate was fired at 1000 °C for 1 hour to form a SiO₂ film 2 µm in thickness on the surface of the SiC ceramic substrate.
   This formed body was subjected to drilling to make a portion which would be through hole, into which a lifter pin for a semiconductor wafer is inserted, and portions (diameter: 1.1 mm, and depth: 2 mm) which would be bottomed holes, in which thermocouples are embedded.
(4) A conductor containing paste was printed on the heater plate obtained in the step (3) by screen printing. The printed pattern was made to a pattern of a combination of concentric circles and a winding line as shown in FIG. 1.
   The used conductor containing paste was the following composition: a composition made of 90 parts by weight of scaly silver (by Shouei Chemical Products Co., Ltd., Ag-540), 10 parts by weight of needle crystal of platinum (by Shouei Chemical Products Co., Ltd., Pt-401), 7.5 parts by weight of silica, 1.5 parts by weight of boron oxide, 6 parts by weight of zinc oxide, and 30 parts by weight of cellulose acetate as an organic vehicle.
(5) Next, the ceramic substrate on which the conductor containing paste was printed was heated and fired at 780 °C to sinter silver and platinum in the conductor containing paste, and bake them onto the substrate. Thus, the resistance heating element was formed. The resistance heating element had a thickness of 5 µm, a width of 10 mm and a area resistivity of 0.13 mΩ/□. A dispersion in the thickness was ± 0.5 µm as a whole. However, the dispersion was not localized.
(6) The substrate formed in the step (5) was immersed into an electroless nickel depositing bath consisting of an aqueous solution containing 80 g/L of nickel sulfate, 24 g/L of sodium hypophosphite, 12 g/L of sodium acetate, 8 g/L of boric acid, and 6 g/L of ammonium chloride to precipitate the metal covering layer (nickel layer) 17 having a thickness of 1 µm on the surface of the silver-lead resistance heating element 12.
(7) A silver-lead solder paste (made by Tanaka Kikinzoku kogyo K. K.) was printed to form a solder layer by screen printing on portions to which the external terminals 13 for attaining connection to a power source were attached.
   Next, terminal pins made of koval were put on the solder layer and heated at 420 °C for reflowing to attach the external terminals 13 onto the surface of the resistance heating element.
(8) Thermocouples for controlling temperature were fitted, into the bottomed holes and a ceramic adhesive (Aron ceramic, made by Toagosei Co., Ltd.) was filled thereto, so as to obtain the ceramic heater.

### (Test Example)

A ceramic heater was produced in the same way as in Example 1 except that a composition made of 100 parts by weight of aluminum nitride powder (average particle diameter: 1.1 µm), 4 parts by weight of yttria (average particle diameter: 0.4 µm), 12 parts by weight of an acrylic binder and an alcohol was subjected to spray-drying to make granular powder.

### (Comparative Example 1)

(1) A ceramic heater was produced in the same way as in Example 1 except that a conductor containing paste was printed in the manner that the pattern of its resistance heating element would be the same as in the ceramic heater 30 shown in FIG. 5. Its thickness was 6 µm, but a dispersion therein was ± 0.4 µm. Moreover, the dispersion in the thickness was thick along the direction perpendicular to the printing direction and was thin along the direction parallel thereto. The dispersion was localized.

Next, an electric current was sent to the ceramic heaters obtained in Examples and the Comparative Example to raise the temperature of the central portion thereof to 200 °C, and then a temperature difference ΔT between the central portion and the peripheral portion (a point 20 mm apart from the peripheral end toward the center) was measured. Time for raising the temperature to 200 °C was also measured.

As a result, data on the ceramic heaters obtained in Examples 1 to 3 and Test Example were as follows: ΔT = 0.5 °C (Example 1), ΔT = 0.5 °C (Example 2), ΔT = 0.4 °C (Example 3), and ΔT = 0.8 °C (Test Example). Thus, the temperature difference between the central portion and the peripheral portion was not very large. Whereas on the ceramic heater obtained in Comparative Example 1, ΔT was 3 °C, thus, a large temperature difference was generated between the central portion and the peripheral portion.

The time for raising the temperature to 200 °C was as follows: 30 seconds (Example 1), 32 seconds (Example 2), 40 seconds (Example 3), and 5 minutes (Test Example). The time in Comparative Example 1 was 30 seconds.

The above-mentioned results demonstrated that considering the temperature-rising time and so on, adoption of non-oxide ceramics was more profitable than adoption of oxide ceramics.

### Industrial Applicability

As described above, according to the present invention, a resistance heating element having a concentric or spiral pattern is formed in the central portion thereof while a resistance heating element having a pattern of repeated winding lines is formed in the peripheral portion thereof. It is therefore possible to suppress a drop in temperature in the peripheral portion in the wafer-heating surface and heat the whole of a semiconductor wafer, which is an object to be heated, uniformly.

## Claims

1. A ceramic heater, wherein a resistance heating element is arranged on a surface of a disc-shaped ceramic substrate or inside the substrate,
characterized in that said resistance heating element is composed of a mixture of a resistance heating element having a concentric or spiral pattern and a resistance heating element having a pattern of a winding line.

2. A ceramic heater, wherein a resistance heating element is arranged on a surface of a disc-shaped ceramic substrate or inside the substrate,
characterized in that said resistance heating element is composed of a mixture of a resistance heating element having a concentric or spiral pattern and a resistance heating element having a pattern of repeated winding lines.

3. The ceramic heater according to claim 1 or 2, wherein the resistance heating element having the pattern of the winding line or the pattern of the repeated winding lines is formed at least in a peripheral portion of the disc-shaped ceramic substrate.

4. The ceramic heater according to any of claims 1 to 3, wherein said ceramic substrate is made of a non-oxide ceramic.

5. The ceramic heater according to any of claims 1 to 3, wherein said ceramic substrate is made of a nitride ceramic.

6. The ceramic heater according to any of claims 1 to 3, wherein said ceramic substrate is made of a carbide ceramic.
